# EUROPEAN PATENT SPECIFICATION

(11) **EP 3 525 559 B1**
(45) Date of publication and mention of the grant of the patent: **09.02.2022**
(21) Application number: 17870315.3
(22) Date of filing: 24.05.2017
(51) Int. Cl.: H05K 5/04, C23C 4/02, C23C 4/08, C23C 14/02, C23C 14/16, C23C 24/04, C23C 28/02, H01Q 1/24, H01Q 1/38

(54) **METAL CASING AND MANUFACTURING METHOD THEREOF**
METALLGEHÄUSE UND HERSTELLUNGSVERFAHREN DAFÜR
BOÎTIER MÉTALLIQUE ET SON PROCÉDÉ DE FABRICATION

(30) Priority: 14.11.2016 CN 201611029701
(43) Date of publication of application: 14.08.2019
(73) Proprietor: Huawei Technologies Co., Ltd., Longgang District Shenzhen, Guangdong 518129 (CN)
(72) Inventor: KE, Youhe, Shenzhen Guangdong 518129 (CN); WANG, Yongxiang, Shenzhen Guangdong 518129 (CN); CAI, Ming, Shenzhen Guangdong 518129 (CN); MA, Rong, Shenzhen Guangdong 518129 (CN)
(74) Representative: Goddar, Heinz J.
(86) International application number: PCT/CN2017/085762
(87) International publication number: WO 2018/086332

(56) References cited:
- EP-A1- 2 355 242
- EP-B1- 1 915 039
- CN-A- 105 556 002
- CN-A- 106 099 318
- CN-A- 106 603 770
- CN-A- 106 654 578
- CN-U- 201 689 978
- CN-U- 204 243 200
- CN-Y- 201 204 582
- US-A1- 2012 251 839
- US-B2- 8 866 679

## Description

### TECHNICAL FIELD

The present invention relates to the field of electronic device manufacturing technologies, and in particular, to a metal enclosure and a metal enclosure manufacturing method.

### BACKGROUND

Currently, most electronic devices use metal enclosures, and use the metal enclosures as antennas or parts of antennas of the electronic devices, to reduce space occupied by the antenna. Therefore, the electronic devices are miniaturized, ultra-thin, and more portable for a user.

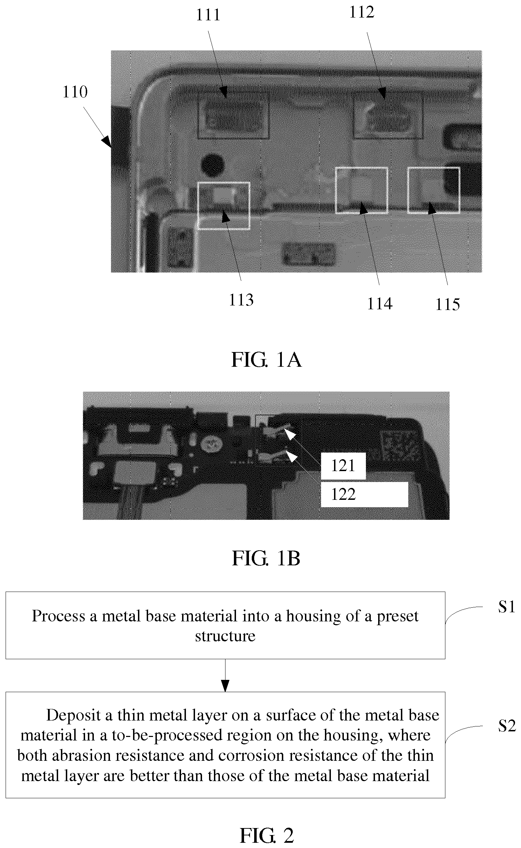

FIG. 1A is a schematic diagram of a partial cavity structure of a metal enclosure of an existing electronic device. FIG. 1B is a schematic diagram of a partial mainboard structure of an electronic device. Referring to FIG. 1A, tens of electrical connection contacts are usually disposed in a cavity of the metal enclosure, and the cavity includes regions marked by reference numerals 111 to 115. Accordingly, referring to FIG. 1B, metal spring plates shown by reference numerals 121 and 122 are disposed on a mainboard. After the metal enclosure is installed on the electronic device, the electrical connection contacts are in contact with the metal spring plates, so that the mainboard is conducted to the metal enclosure, and the metal enclosure can be used as an antenna or a part of an antenna to send or receive data.

To ensure antenna performance, the metal enclosure and the mainboard need to be well conducted, that is, resistance of the electrical connection contacts and the metal spring plates needs to be as small as possible (usually less than 200 mΩ). In actual application, an aluminum alloy material is usually used for the metal enclosure. An electrical connection contact on an aluminum alloy housing repeatedly rubs with the metal spring plate on the mainboard, and consequently, an aluminum alloy particle is generated on a surface of the electrical connection contact. The aluminum alloy particle is extremely easily oxidized and attached to the surface of the electrical connection contact or a surface of the metal spring plate that is in contact with the electrical connection contact. Consequently, resistance of the electrical connection contact and the metal spring plate is increased, and antenna performance deteriorates.

For the foregoing technical problem, currently, some manufacturers weld a metal slice to an electrical connection contact by using a laser welding technology or an ultrasonic welding technology, or fasten a metal slice to an electrical connection contact by using a screw. The metal slice is in direct contact with a metal spring plate on a mainboard, so that a resistance increase caused by oxidation of the electrical connection contact is avoided. However, in all these three technologies, an area of the electrical connection contact is restricted. If the area of the electrical connection contact is excessively small, it is extremely difficult to fasten the metal slice to the electrical connection contact. As shown in FIG. 1A, an electrical connection contact 111 and an electrical connection contact 112 have relatively large area, and a metal slice can be fastened to the electrical connection contacts, but an electrical connection contact 113, an electrical connection contact 114, and an electrical connection contact 115 have relatively small area, and are not suitable for fastening a metal slice. It can be learned from actual operations that the area of the electrical connection contact needs to be no less than 3 mm×3 mm if the laser welding technology is used, and the area of the electrical connection contact needs to be no less than 2 mm×2 mm if the ultrasonic welding technology is used. Therefore, when cavity space of the metal enclosure is limited, it is extremely difficult to set a relatively large area for each electrical connection contact. A problem of a resistance increase of each electrical connection contact in a using process is far from being resolved by using the foregoing three technologies.

EP 2 355 242 A1 discloses an antenna device for a portable radio communication device. The antenna device comprises a metal cover for the portable radio communication device, wherein the metal cover comprises a front side part, a first back side part connected to the front side part through a top side part, a second back side part connected to the front side part through a bottom side part, wherein the bottom and top side parts are positioned at opposite ends of the front side part, and the first and second back side parts are positioned essentially coplanar and distanced from each other by a slot, the first back side part comprises a feed point and a ground point, and the first back side part is fed through the feed point.

### SUMMARY

The present invention is to provide a metal enclosure and a metal enclosure manufacturing method, so as to resolve a problem of a resistance increase of an electrical connection contact on a metal enclosure in a using process, and improve conduction performance of the metal enclosure used as an antenna.

The present invention provides a metal enclosure manufacturing method, including:
processing a metal base material into a housing of a preset structure; and
depositing a thin metal layer on a surface of the metal base material in a to-be-processed region on the housing, where
the to-be-processed region is a region that is on the housing and that is used as an electrical connection contact, and both abrasion resistance and corrosion resistance of the thin metal layer are better than those of the metal base material.

According to the metal enclosure manufacturing method of the present invention, a thin metal layer is deposited in the electrical connection contact region on a housing, and both abrasion resistance and corrosion resistance of the thin metal layer are better than those of a metal base material used for the housing. In the prior art, a metal base material in an electrical connection contact region is directly exposed. By contrast, in an actual process of using a metal enclosure manufactured in the present invention, the thin metal layer covering the metal base material is exposed on the electrical connection contact. The abrasion resistance and the corrosion resistance of the thin metal layer are better than those of the metal base material. Therefore, in comparison with the prior art, the electrical connection contact is less likely to be abraded and oxidized, so as to avoid conductivity reduction of the electrical connection contact in the process of using the metal enclosure, and ensure that conduction performance between the metal enclosure and a mainboard is always in a good state. In addition, in the prior art, a metal slice is fastened to an electrical connection contact by means of laser welding, ultrasonic welding, screwing, or the like. By contrast, in the present invention, deposition of the thin metal layer is not limited by cavity space of the housing, and may be implemented on an electrical connection contact of any area size. Therefore, in the present invention, a conduction problem of an electrical connection contact on a metal enclosure can be thoroughly resolved.

In a possible design, the depositing a thin metal layer on a surface of the metal base material in a to-be-processed region on the housing includes:
depositing the thin metal layer on the surface of the metal base material in the to-be-processed region in a preset deposition manner, where
the preset deposition manner includes but is not limited to any one of the following: cold metal spraying, hot metal spraying, electroplating, or physical vapor deposition PVD.

In a possible design, the depositing a thin metal layer on a surface of the metal base material in a to-be-processed region on the housing includes:
depositing a nickel layer on the surface of the metal base material in the to-be-processed region; or
depositing a copper layer on the surface of the metal base material in the to-be-processed region; or
successively depositing a nickel layer and a copper layer on the surface of the metal base material in the to-be-processed region; or
successively depositing a copper layer and a nickel layer on the surface of the metal base material in the to-be-processed region; or
successively depositing a nickel layer and a gold layer on the surface of the metal base material in the to-be-processed region.

This implementation provides a method for depositing a single thin metal layer on the surface of the metal base material in the to-be-processed region and a method for depositing double thin metal layers on the surface of the metal base material in the to-be-processed region. For a case in which a single thin metal layer is deposited in the electrical connection contact region, it can be learned from an actual test result that corrosion resistance of an electrical connection contact deposited with the nickel layer is better than corrosion resistance of an electrical connection contact deposited with the copper layer, but resistivity of the electrical connection contact deposited with the nickel layer is higher than resistivity of the electrical connection contact deposited with the copper layer, that is, conductivity of the electrical connection contact deposited with the nickel layer is slightly worse than conductivity of the electrical connection contact deposited with the copper layer. Accordingly, for a case in which double thin metal layers are deposited, when an upper layer is the nickel layer, corrosion resistance of an electrical connection contact is better than corrosion resistance of electrical connection contacts in a case in which an upper layer is the copper layer and a case in which a single copper layer is deposited, and resistivity is higher than that in a case of a single nickel layer and a case of a single copper layer. When the gold layer is used in a double thin metal layer structure, the gold layer is disposed at an upper layer, so as to ensure that the electrical connection contact region on the housing has excellent conductivity and corrosion resistance. The nickel layer is preferably selected as a lower layer, so as to ensure that the electrical connection contact region has fine abrasion resistance. Based on the foregoing test results and analysis, a material of the thin metal layer may be selected according to a requirement on corrosion resistance and conductivity of the electrical connection contact in an actual application scenario.

In a possible design, both a thickness of the nickel layer and a thickness of the copper layer are between 10 µm and 500 µm, and a thickness of the gold layer is greater than 200 nm.

In a possible design, the processing a metal base material into a housing of a preset structure includes:
processing a first metal base material into the housing of the preset structure by using a first formation technology, where
the first formation technology includes but is not limited to any one of the following: stamping, forging, numerical control machining, or die casting; and
the first metal base material includes but is not limited to any of the following: a 5000-series aluminum alloy, a 6000-series aluminum alloy, or a 7000-series aluminum alloy.

According to the invention, before the depositing a thin metal layer on a surface of the metal base material in a to-be-processed region on the housing, the method further includes:
forming an anodized film on a surface of the housing by means of anodizing processing; and
removing the anodized film in the to-be-processed region by using a laser engraving technology or a numerical control machining technology, to expose the metal base material in the to-be-processed region.

In this implementation, the metal base material used for the housing is an aluminum alloy or a magnesium alloy, and the anodized film may be formed on the surface of the housing by means of anodizing processing. The anodized film can not only beautify the housing and provide different appearance colors, but also protect the housing from corrosion.

In a possible design, the processing a metal base material into a housing of a preset structure includes:
processing a second metal base material into the housing of the preset structure by using a die casting technology and a numerical control machining technology, where
the second metal base material includes but is not limited to either of the following: a die casting aluminum alloy or a die casting magnesium alloy.

According to an alternative of the invention, before the depositing a thin metal layer on a surface of the metal base material in a to-be-processed region on the housing, the method further includes:
forming a chemical conversion film on a surface of the housing by means of chemical conversion film processing; and
removing the chemical conversion film in the to-be-processed region by using a laser engraving technology or a numerical control machining technology, to expose the metal base material in the to-be-processed region.

In this implementation, the metal base material user for the housing is a die casting aluminum alloy or a die casting magnesium alloy, and the chemical conversion film is formed on the surface of the housing by means of chemical conversion film processing. The chemical conversion film can protect the housing from oxidation and corrosion.

To avoid oxidation, corrosion, abrasion, or the like in a process of using the housing, in this embodiment of the present invention, a protective film is disposed on a surface of a region on the housing other than the to-be-processed region. For ease of actual processing, in this embodiment of the present invention, the protective film is first disposed on the entire housing, and then the protective film in the to-be-processed region is removed by performing film rupture processing on the to-be-processed region, to expose the metal base material in the to-be-processed region, so that the thin metal layer can be deposited on the surface of the metal base material.

According to a second aspect, the present invention provides a metal enclosure, including a housing, where
a thin metal layer is deposited on a surface of a metal base material in an electrical connection contact region on the housing, and abrasion resistance and corrosion resistance of the thin metal layer are better than those of the metal base material.

According to the metal enclosure in the present invention, a thin metal layer is deposited in an electrical connection contact region on a housing, and both abrasion resistance and corrosion resistance of the thin metal layer are better than those of a metal base material used for the housing. In the prior art, a metal base material in an electrical connection contact region is directly exposed. By contrast, in an actual process of using the metal enclosure manufactured in this embodiment of the present invention, the thin metal layer covering the metal base material is exposed on the electrical connection contact. The abrasion resistance and the corrosion resistance of the thin metal layer are better than those of the metal base material. Therefore, in comparison with the prior art, in the present invention, the electrical connection contact is less likely to be abraded and oxidized, so as to avoid conductivity reduction of the electrical connection contact in the process of using the metal enclosure, and ensure that conduction performance between the metal enclosure and a mainboard is always in a good state. In addition, in the prior art, a metal slice is fastened to an electrical connection contact by means of laser welding, ultrasonic welding, screwing, or the like. By contrast, in this embodiment of the present invention, deposition of the thin metal layer is not limited by cavity space of the housing, and may be implemented on an electrical connection contact of any area size. Therefore, in this embodiment of the present invention, a conduction problem of an electrical connection contact on a metal enclosure can be thoroughly resolved.

In a possible design, the metal enclosure includes but is not limited to any one of the following: a middle frame, a rear cover, or a screen support board of an electronic device.

In a possible design, the thin metal layer includes:
a nickel layer deposited on the surface of the metal base material in the electrical connection contact region; or
a copper layer deposited on the surface of the metal base material in the electrical connection contact region; or
a nickel layer and a copper layer that are successively deposited on the surface of the metal base material in the electrical connection contact region; or
a copper layer and a nickel layer that are successively deposited on the surface of the metal base material in the electrical connection contact region; or
a nickel layer and a copper layer that are successively deposited on the surface of the metal base material in the electrical connection contact region.

This implementation discloses a method for depositing a single thin metal layer or double thin metal layers on the surface of the metal base material in the electrical connection contact region. For a case in which a single thin metal layer is deposited in the electrical connection contact region, it can be learned from an actual test result that corrosion resistance of an electrical connection contact deposited with the nickel layer is better than corrosion resistance of an electrical connection contact deposited with the copper layer, but resistivity of the electrical connection contact deposited with the nickel layer is higher than resistivity of the electrical connection contact deposited with the copper layer, that is, conductivity of the electrical connection contact deposited with the nickel layer is slightly worse than conductivity of the electrical connection contact deposited with the copper layer. Accordingly, for a case in which double thin metal layers are deposited, when an upper layer is the nickel layer, corrosion resistance of an electrical connection contact is better than corrosion resistance of electrical connection contacts in a case in which an upper layer is the copper layer and a case in which a single copper layer is deposited, and resistivity is higher than that in a case of a single nickel layer and a case of a single copper layer. When the gold layer is used in a double thin metal layer structure, the gold layer is disposed at an upper layer, so as to ensure that the electrical connection contact region on the housing has excellent conductivity and corrosion resistance. The nickel layer is preferably selected as a lower layer, so as to ensure that the electrical connection contact region has fine abrasion resistance. Based on the foregoing test results and analysis, in a process of manufacturing the metal enclosure, a material of the thin metal layer may be selected according to a requirement on corrosion resistance and conductivity of the electrical connection contact in an actual application scenario of the metal enclosure.

In a possible design, both a thickness of the nickel layer and a thickness of the copper layer are between 10 µm and 500 µm, and a thickness of the gold layer is greater than 200 nm.

In a possible design, the housing is obtained by processing a first metal base material by using a first formation technology;
the first formation technology includes but is not limited to any one of the following: stamping, forging, numerical control machining, or die casting; and
the first metal base material includes but is not limited to any of the following: a 5000-series aluminum alloy, a 6000-series aluminum alloy, or a 7000-series aluminum alloy.

According to the invention, an anodized film or a chemical conversion thin film is disposed on a non-electrical connection contact region on the housing.

In a possible design, the housing is obtained by processing a second metal base material by using a die casting technology; and
the second metal base material includes but is not limited to either of the following: a die casting aluminum alloy or a die casting magnesium alloy.

To avoid oxidation, corrosion, abrasion, or the like in a process of using the housing, in this embodiment of the present invention, a protective film is disposed on a surface of a region on the housing other than the to-be-processed region. For different metal base materials, different types of protective films may be used. When the metal base material is an aluminum alloy or a magnesium alloy, an anodized film may be formed on the surface of the housing by means of anodizing processing. The anodized film can not only beautify the housing and provide different appearance colors, but also protect the housing from corrosion. When the metal base material is a die casting aluminum alloy or a die casting magnesium alloy, a chemical conversion film may be formed on the surface of the housing by means of chemical conversion film processing. The chemical conversion film can protect the housing from oxidation and corrosion.

### BRIEF DESCRIPTION OF DRAWINGS

To describe the technical solutions in the embodiments of the present invention more clearly, the following briefly describes the accompanying drawings required for the embodiments.
FIG. 1A is a schematic diagram of a partial cavity structure of a metal enclosure of an existing electronic device;
FIG. 1B is a schematic diagram of a partial mainboard structure of an existing electronic device;
FIG. 2 is a flowchart of a metal enclosure manufacturing method according to an embodiment of the present invention;

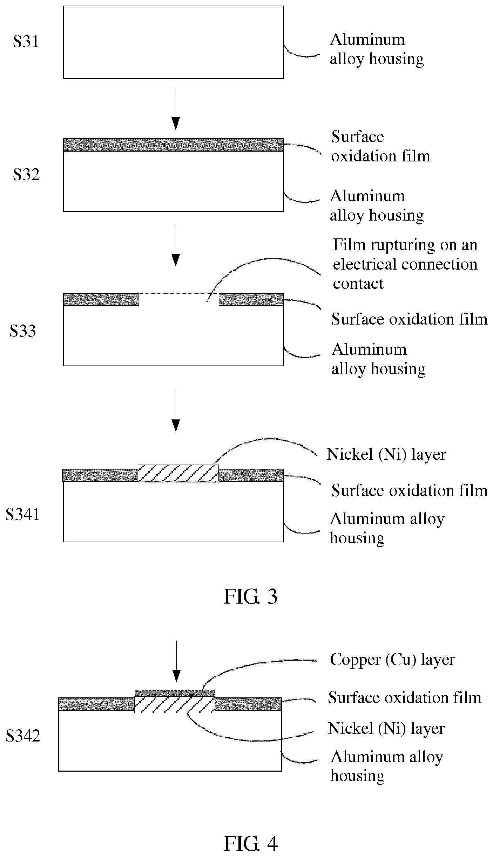

FIG. 3 is a schematic diagram of a change in a cross-sectional structure of a metal enclosure according to an embodiment of the present invention in a process of implementing a metal enclosure manufacturing method in which an aluminum alloy is used as a base material and a single nickel layer is deposited;
FIG. 4 is a schematic diagram of a change of a cross-sectional structure of a metal enclosure according to an embodiment of the present invention in a process of implementing a metal enclosure manufacturing method in which an aluminum alloy is used as a base material and double thin metal layers are deposited;

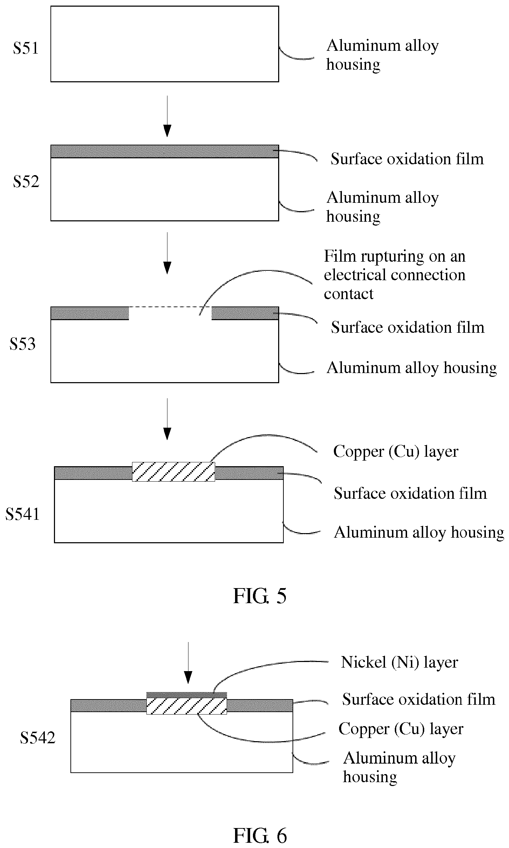

FIG. 5 is a schematic diagram of a change in a cross-sectional structure of a metal enclosure according to an embodiment of the present invention in a process of implementing a metal enclosure manufacturing method in which an aluminum alloy is used as a base material and a single copper layer is deposited;
FIG. 6 is a schematic diagram of a change in a cross-sectional structure of a metal enclosure according to an embodiment of the present invention in a process of implementing another metal enclosure manufacturing method in which an aluminum alloy is used as a base material and double thin metal layers are deposited;

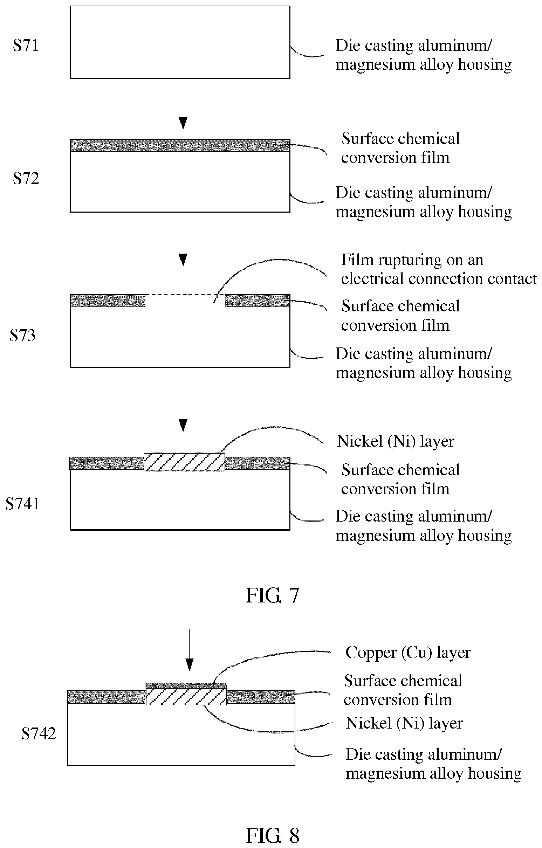

FIG. 7 is a schematic diagram of a change in a cross-sectional structure of a metal enclosure according to an embodiment of the present invention in a process of implementing a metal enclosure manufacturing method in which a die casting aluminum/magnesium alloy is used as a base material and a single nickel layer is deposited;
FIG. 8 is a schematic diagram of a change in a cross-sectional structure of a metal enclosure according to an embodiment of the present invention in a process of implementing a metal enclosure manufacturing method in which a die casting aluminum/magnesium alloy is used as a base material and double thin metal layers are deposited;

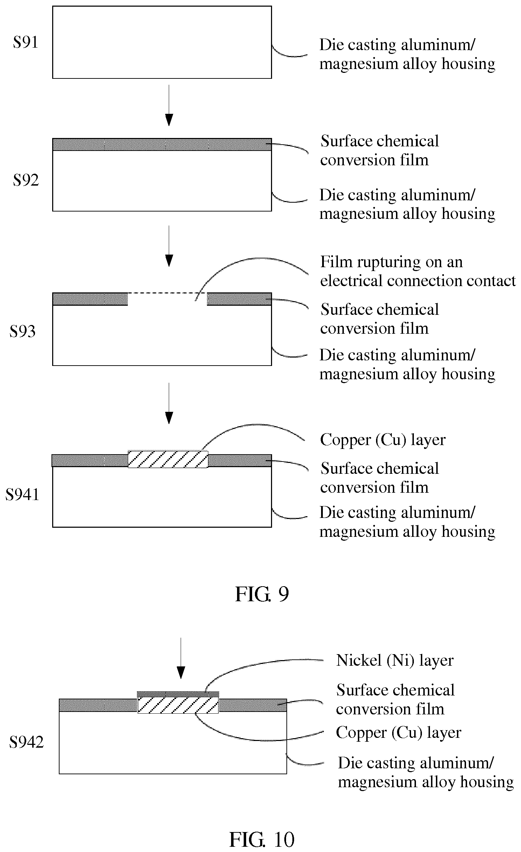

FIG. 9 is a schematic diagram of a change in a cross-sectional structure of a metal enclosure according to an embodiment of the present invention in a process of implementing a metal enclosure manufacturing method in which a die casting aluminum/magnesium alloy is used as a base material and a single copper layer is deposited;
FIG. 10 is a schematic diagram of a change in a cross-sectional structure of a metal enclosure according to an embodiment of the present invention in a process of implementing another metal enclosure manufacturing method in which a die casting aluminum/magnesium alloy is used as a base material and double thin metal layers are deposited; and

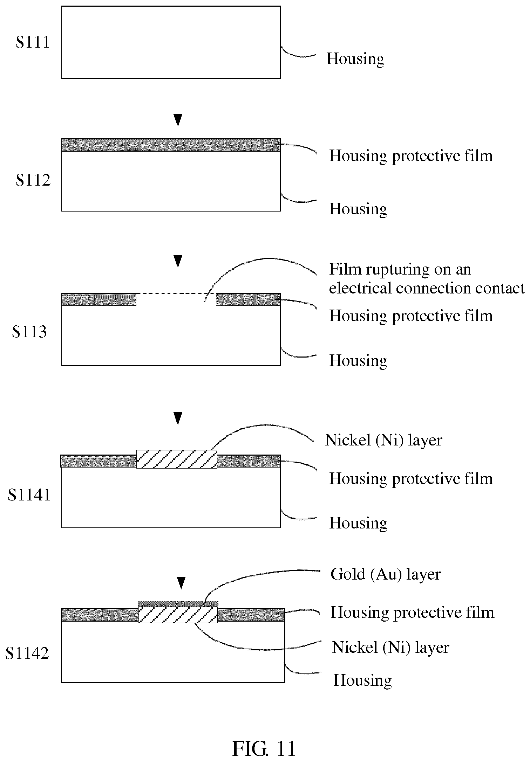

FIG. 11 is a schematic diagram of a change in a cross-sectional structure of a metal enclosure according to an embodiment of the present invention in a process of implementing a metal enclosure manufacturing method in which a nickel layer and a gold layer are deposited in an electroplating manner.

### DESCRIPTION OF EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by persons of ordinary skill in the art based on the embodiments of the present invention without creative efforts shall fall within the protection scope of the present invention.

FIG. 2 is a flowchart of a metal enclosure manufacturing method according to an embodiment of the present invention. As shown in FIG. 2, the method includes the following steps.

S1. Process a metal base material into a housing of a preset structure.

The preset structure of the foregoing housing is determined by a type of the metal enclosure. The metal enclosure in this embodiment of the present invention may be any type of housing that is of any electronic device and on which an electrical connection contact needs to be disposed, such as a middle frame, a rear cover, or a screen support board of a cell phone, or a rear cover or a screen support board of a tablet computer. The middle frame and the rear cover are support mechanical parts on which a printed circuit board (Printed Circuit Board, PCB) and various chips and batteries are placed. The screen support board is a support mechanical part that supports a screen of an electronic device.

S2. Deposit a thin metal layer on a surface of the metal base material in a to-be-processed region on the housing.

The to-be-processed region is a region that is on the housing and that is used as an electrical connection contact.

In this embodiment of the present invention, during manufacturing of the metal enclosure, the thin metal layer is deposited in the region, that is, the to-be-processed region, that is on the housing and that is used as the electrical connection contact. Both abrasion resistance and corrosion resistance of a material used for the thin metal layer are better than those of the metal base material. Certainly, when abrasion or corrosion caused by an external force is not considered, conductivity of the thin metal layer also needs to meet a performance requirement on conductivity between the metal enclosure and a mainboard. Specifically, a metal material whose resistivity is less than 130 nΩ·m may be selected to manufacture the thin metal layer.

In the prior art, a metal base material on an electrical connection contact is directly exposed, and the metal base material is in direct contact with a metal spring plate on a mainboard. Therefore, in a using process, metal particles are generated in repeated slight rubbing between the metal base material and the metal spring plate, and conductivity deterioration of the electrical connection contact is caused by oxidization and accumulation of the metal particles. However, in this embodiment of the present invention, the thin metal layer is deposited on the surface of the metal base material in the electrical connection contact region, so that in a using process, the metal base material in the electrical connection contact region is not exposed, but instead, the thin metal layer is exposed and is in contact with a metal spring plate. The thin metal layer has high abrasion resistance and high corrosion resistance, and no metal particle is generated after repeated slight rubbing between the thin metal layer and the metal spring plate. In this way, conductivity reduction of an electrical connection contact in a process of using the metal enclosure can be avoided, conduction performance between the metal enclosure and a mainboard is ensured to be always in a good state, and performance of the metal enclosure is kept fine when the metal enclosure is used as an antenna.

In addition, in the prior art, a metal slice is fastened to an electrical connection contact by means of laser welding, ultrasonic welding, screwing, or the like. By contrast, in this embodiment of the present invention, deposition of the thin metal layer is not limited by cavity space of the housing, and may be implemented on an electrical connection contact of any area size. Therefore, in this embodiment of the present invention, a conduction problem of an electrical connection contact on a metal enclosure can be thoroughly resolved.

Optionally, the metal material used for the thin metal layer may be nickel (Ni), copper (Cu), gold (Au), silver (Ag), or the like. Nickel and copper with lower prices are preferably selected.

Optionally, in step S2, a manner used for depositing the thin metal layer includes but is not limited to any one of the following: electroplating, cold metal spraying, hot metal spraying, or physical vapor deposition (Physical Vapor Deposition, PVD).

In addition, a non-electrical connection contact region may be blocked by using a blocking technology (such as an ink-jet blocking technology) before a deposition operation is performed, to avoid spraying the thin metal layer on a surface of the non-electrical connection contact region by mistake, and to avoid a short circuit between neighboring electrical connection contacts.

In the present invention, after the foregoing step S1 is performed and before S2 is performed, the metal enclosure manufacturing method includes the following step:
disposing a protective film on a surface of the housing, and performing film rupture processing on the to-be-processed region.

To avoid oxidation, corrosion, abrasion, or the like in a process of using the housing, in this embodiment of the present invention, the protective film is disposed on a surface of a region on the housing other than the to-be-processed region. For ease of actual processing, in this embodiment of the present invention, the protective film is first disposed on the entire housing, and then the protective film in the to-be-processed region is removed by performing film rupture processing on the to-be-processed region, to expose the metal base material in the to-be-processed region, so that the thin metal layer can be deposited on the surface of the metal base material (step S2).

The protective film in the to-be-processed region is removed by using a laser engraving technology or a numerical control (Computer numerical control, CNC) machining technology.

Different types of protective films may be used for different metal base materials.

For example, when the metal base material is an aluminum alloy or a magnesium alloy, an anodized film is formed on the surface of the housing by means of anodizing processing. The anodized film can not only beautify the housing and provide different appearance colors, but also protect the housing from corrosion. When the metal base material is a die casting aluminum alloy or a die casting magnesium alloy, a chemical conversion film is formed on the surface of the housing by means of chemical conversion film processing. The chemical conversion film can protect the housing from oxidation and corrosion.

In a feasible embodiment of the present invention, the thin metal layer in the foregoing step S2 may be a single thin metal layer, such as a nickel layer, a copper layer, or a copper alloy layer. Optionally, the copper alloy layer may be specifically formed by means of phosphor bronze deposition.

Optionally, a thickness of the single thin metal layer is between 10 µm and 500 µm.

In a feasible embodiment of the present invention, the thin metal layer in the foregoing step S2 may be double thin metal layers. For example, a lower layer (in direct contact with the metal base material) is a nickel layer, and an upper layer is a copper layer; or a lower layer is a copper layer, and an upper layer is a nickel layer; or a lower layer is a nickel layer, and an upper layer is a gold layer.

Optionally, in the double thin metal layers, both a thickness of the nickel layer and a thickness of the copper layer may be set to a value between 10 µm and 500 µm. A thickness of the gold layer is smaller, may be set to a value at a nanometer (nm) level, and specifically, may be set to a value greater than 200 nm.

According to different materials selected for the metal base material and the thin metal layer, and different processing technologies, the metal enclosure manufacturing method in this embodiment of the present invention may have multiple different implementations. FIG. 3 to FIG. 11 are separately schematic diagrams of a change in a cross-sectional structure of a metal enclosure in a process of implementing a metal enclosure manufacturing method provided in a specific embodiment of the present invention. Specific steps of the metal enclosure manufacturing method provided in this embodiment of the present invention are described below with reference to the schematic diagrams of a change in a cross-sectional structure.

Referring to FIG. 3, in a feasible implementation of the present invention, the foregoing metal enclosure manufacturing method includes the following steps.

S31. Process a first metal base material into a housing of a preset structure by using a first formation technology.

The first formation technology includes but is not limited to any one of the following: stamping, forging, numerical control machining, or die casting. The first metal base material includes but is not limited to any of the following: a 5000-series aluminum alloy, a 6000-series aluminum alloy, or a 7000-series aluminum alloy.

S32. Form an anodized film on a surface of the housing by means of anodizing processing.

S33. Perform film rupture processing on a to-be-processed region that is on the housing and on which an electrical connection contact needs to be disposed, to remove the anodized film in the to-be-processed region.

Specifically, the oxidation film in the to-be-processed region may be removed by using a laser engraving or CNC machining technology.

S341. Deposit a nickel layer in the to-be-processed region.

A thickness of the nickel layer is controlled between 10 µm and 500 µm. Specifically, the nickel layer may be formed by means of deposition in a deposition manner such as cold metal spraying, hot metal spraying, or PVD.

In the foregoing implementation, nickel layers are deposited in all electrical connection contact regions in a cavity of a metal enclosure, so that a surface of an aluminum alloy base material in the electrical connection contact region can be protected from oxidation. It can be learned from an actual test that, for an aluminum alloy enclosure on which the nickel layer is deposited and that is obtained in the foregoing implementation, Z-resistance of the electrical connection contact region is less than 50 mΩ in actual measurement, and after 8-hour, 12-hour, and 24-hour neutral salt spray tests, a nickel layer of each electrical connection contact is not obviously corroded, Z-resistance is not obviously increased, and conductivity performance is kept fine. It can be learned that, in comparison with the prior art in which a metal base material of a housing is directly exposed to form an electrical connection contact, oxidation resistance and corrosion resistance of the aluminum alloy enclosure manufactured in the foregoing implementation are greatly improved.

Referring to FIG. 4, in a feasible implementation of the present invention, based on step S31 to step S341 shown in FIG. 3, the foregoing metal enclosure manufacturing method may further include the following step:
S342. Deposit a copper layer on the nickel layer.

After step S342 is performed, double thin metal layers are successively deposited in the to-be-processed region corresponding to the electrical connection contact. A thickness of the nickel layer at a first layer is controlled between 10 µm and 500 µm, and a thickness of the copper layer at a second layer is also controlled between 10 µm and 500 µm.

In the foregoing implementation, double thin metal layers are deposited in all electrical connection contact regions in a cavity of a metal enclosure, so that a surface of an aluminum alloy base material in the electrical connection contact region can be protected from oxidation. It can be learned from an actual test that, for an aluminum alloy enclosure on which the double thin metal layers are deposited and that is obtained in the foregoing implementation, Z-resistance of the electrical connection contact region is less than 60 mΩ in actual measurement, and after an 8-hour neutral salt spray test, double thin metal layers of each electrical connection contact are not obviously corroded, Z-resistance is not obviously increased, and conductivity performance is kept fine. It can be learned that, in comparison with the prior art in which a metal base material of a housing is directly exposed to form an electrical connection contact, oxidation resistance and corrosion resistance of the aluminum alloy enclosure manufactured in the foregoing implementation are greatly improved.

Referring to FIG. 5, in the present invention, the foregoing metal enclosure manufacturing method includes the following steps.

S51. Process a first metal base material into a housing of a preset structure by using a first formation technology.

The first formation technology includes but is not limited to any one of the following: stamping, forging, numerical control machining, or die casting. The first metal base material includes but is not limited to any of the following: a 5000-series aluminum alloy, a 6000-series aluminum alloy, or a 7000-series aluminum alloy.

S52. Form an anodized film on a surface of the housing by means of anodizing processing.

S53. Perform film rupture processing on a to-be-processed region that is on the housing and on which an electrical connection contact needs to be disposed, to remove the anodized film in the to-be-processed region.

Specifically, the anodized film in the to-be-processed region may be removed by using a laser engraving or CNC machining technology.

S541. Deposit a copper layer in the to-be-processed region.

A thickness of the copper layer is controlled between 10 µm and 500 µm. Specifically, the copper layer may be formed by means of deposition in a deposition manner such as cold metal spraying, hot metal spraying, or PVD.

Optionally, the copper layer deposited in step S541 may further be replaced with a copper alloy layer.

In the foregoing implementation, the copper layer is deposited in all electrical connection contact regions in a cavity of a metal enclosure, so that a surface of an aluminum alloy base material in the electrical connection contact region can be protected from oxidation. It can be learned from an actual test that, for an aluminum alloy enclosure on which the copper layer is deposited and that is obtained in the foregoing implementation, Z-resistance of the electrical connection contact region is less than 30 mΩ in actual measurement, and after an 8-hour neutral salt spray test, a copper layer of each electrical connection contact is not obviously corroded, Z-resistance is not obviously increased, and conductivity performance is kept fine. It can be learned that, in comparison with the prior art in which a metal base material of a housing is directly exposed to form an electrical connection contact, oxidation resistance and corrosion resistance of the aluminum alloy enclosure manufactured in the foregoing implementation are greatly improved.

Referring to FIG. 6, in a feasible implementation of the present invention, based on step S51 to step S541 shown in FIG. 5, the foregoing metal enclosure manufacturing method may further include the following step:
S542. Deposit a nickel layer on the copper layer.

After step S542 is performed, double thin metal layers are successively deposited in the to-be-processed region corresponding to the electrical connection contact. A thickness of the copper layer at a first layer is controlled between 10 µm and 500 µm, and a thickness of the nickel layer at a second layer is also controlled between 10 µm and 500 µm.

Referring to FIG. 7, in the present invention, the foregoing metal enclosure manufacturing method includes the following steps.

S71. Process a second metal base material into a housing of a preset structure by using a die casting technology and a numerical control machining technology.

The second metal base material includes but is not limited to either of the following: a die casting aluminum alloy or a die casting magnesium alloy. Specifically, a designation of the die casting aluminum alloy may be ADC12, DX19, or the like, and a designation of the die casting magnesium alloy may be AZ31, AZ91, or the like. During processing, the die casting aluminum alloy or the die casting magnesium alloy is first processed into a contour structure of the housing by using the die casting technology, and then the housing formed by means of die casting is processed into a refined structure of the housing by using the numerical control machining technology.

S72. Form a chemical conversion thin film on a surface of the housing by means of chemical conversion film processing.

S73. Perform film rupture processing on a to-be-processed region that is on the housing and on which an electrical connection contact needs to be disposed, to remove the chemical conversion thin film in the to-be-processed region.

Specifically, the chemical conversion thin film in the to-be-processed region is removed by using a laser engraving or CNC machining technology.

S741. Deposit a nickel layer in the to-be-processed region.

A thickness of the nickel layer is controlled between 10 µm and 500 µm. Specifically, the nickel layer may be formed by means of deposition in a deposition manner such as cold metal spraying, hot metal spraying, or PVD.

In the foregoing implementation, the nickel layer is deposited in all electrical connection contact regions in a cavity of a metal enclosure, so that a surface of a die casting metal (the die casting aluminum alloy/the die casting magnesium alloy) base material in the electrical connection contact region can be protected from oxidation. It can be learned from an actual test that, for a die casting metal enclosure on which the nickel layer is deposited and that is obtained in the foregoing implementation, Z-resistance of the electrical connection contact region is less than 50 mΩ in actual measurement, and after 8-hour, 12-hour, and 24-hour neutral salt spray tests, a nickel layer of each electrical connection contact is not obviously corroded, Z-resistance is not obviously increased, and conductivity performance is kept fine. It can be learned that, in comparison with the prior art in which a metal base material of a housing is directly exposed to form an electrical connection contact, oxidation resistance and corrosion resistance of the die casting metal enclosure manufactured in the foregoing implementation are greatly improved.

Referring to FIG. 8, in a feasible implementation of the present invention, based on step S71 to step S741 shown in FIG. 7, the foregoing metal enclosure manufacturing method may further include the following step:
S742. Deposit a copper layer on the nickel layer.

In the implementation shown in FIG. 8, double thin metal layers are successively deposited in the to-be-processed region corresponding to the electrical connection contact. A thickness of the nickel layer at a first layer is controlled between 10 µm and 500 µm, and a thickness of the copper layer at a second layer is also controlled between 10 µm and 500 µm.

In the foregoing implementation, double thin metal layers are deposited in all electrical connection contact regions in a cavity of a metal enclosure, so that a surface of a die casting metal (the die casting aluminum alloy/the die casting magnesium alloy) base material in the electrical connection contact region can be protected from oxidation. It can be learned from an actual test that, for a die casting metal enclosure on which the double thin metal layers are deposited and that is obtained in the foregoing implementation, Z-resistance of the electrical connection contact region is less than 60 mΩ in actual measurement, and after an 8-hour neutral salt spray test, double thin metal layers of each electrical connection contact are not obviously corroded, Z-resistance is not obviously increased, and conductivity performance is kept fine. It can be learned that, in comparison with the prior art in which a metal base material of a housing is directly exposed to form an electrical connection contact, oxidation resistance and corrosion resistance of the die casting metal enclosure manufactured in the foregoing implementation are greatly improved.

Referring to FIG. 9, in a feasible implementation of the present invention, the foregoing metal enclosure manufacturing method includes the following steps.

S91. Process a second metal base material into a housing of a preset structure by using a die casting technology.

The second metal base material includes but is not limited to either of the following: a die casting aluminum alloy or a die casting magnesium alloy.

S92. Form a chemical conversion thin film on a surface of the housing by means of chemical conversion film processing.

S93. Perform film rupture processing on a to-be-processed region that is on the housing and on which an electrical connection contact needs to be disposed, to remove the chemical conversion thin film in the to-be-processed region.

Specifically, the chemical conversion thin film in the to-be-processed region is removed by using a laser engraving or CNC machining technology.

S941. Deposit a copper layer in the to-be-processed region.

A thickness of the copper layer is controlled between 10 µm and 500 µm. Specifically, the copper layer may be formed by means of deposition in a deposition manner such as cold metal spraying, hot metal spraying, or PVD.

Optionally, the copper layer deposited in step S941 may further be replaced with a copper alloy layer.

In the foregoing implementation, the copper layer is deposited in all electrical connection contact regions in a cavity of a metal enclosure, so that a surface of a die casting metal (the die casting aluminum alloy/the die casting magnesium alloy) base material in the electrical connection contact region can be protected from oxidation. It can be learned from an actual test that, for a die casting metal enclosure on which the copper layer is deposited and that is obtained in the foregoing implementation, Z-resistance of the electrical connection contact region is less than 50 mΩ in actual measurement, and after an 8-hour neutral salt spray test, a copper layer of each electrical connection contact is not obviously corroded, Z-resistance is not obviously increased, and conductivity performance is kept fine. It can be learned that, in comparison with the prior art in which a metal base material of a housing is directly exposed to form an electrical connection contact, oxidation resistance and corrosion resistance of the die casting metal enclosure manufactured in the foregoing implementation are greatly improved.

Referring to FIG. 10, in a feasible implementation of the present invention, based on step S91 to step S941 shown in FIG. 9, the foregoing metal enclosure manufacturing method may further include the following step:
S942. Deposit a nickel layer on the copper layer.

After step S942 is performed, double thin metal layers are successively deposited in the to-be-processed region corresponding to the electrical connection contact. A thickness of the copper layer at a first layer is controlled between 10 µm and 500 µm, and a thickness of the nickel layer at a second layer is also controlled between 10 µm and 500 µm.

The foregoing embodiments separately describe a metal enclosure manufacturing method in which a single thin metal layer is deposited on a surface of a metal base material in a to-be-processed region and a metal enclosure manufacturing method in which double thin metal layers are deposited on a surface of a metal base material in a to-be-processed region. For a case in which a single thin metal layer is deposited in the electrical connection contact region, it can be learned from an actual test result that corrosion resistance of an electrical connection contact deposited with the nickel layer is better than corrosion resistance of an electrical connection contact deposited with the copper layer, but resistivity of the electrical connection contact deposited with the nickel layer is higher than resistivity of the electrical connection contact deposited with the copper layer, that is, conductivity of the electrical connection contact deposited with the nickel layer is slightly worse than conductivity of the electrical connection contact deposited with the copper layer. Accordingly, for a case in which double thin metal layers are deposited, when an upper layer is the nickel layer, corrosion resistance of an electrical connection contact is better than corrosion resistance of electrical connection contacts in a case in which an upper layer is the copper layer and a case in which a single copper layer is deposited, and resistivity is higher than that in a case of a single nickel layer and a case of a single copper layer.

Referring to FIG. 11, in a feasible implementation of the present invention, the foregoing metal enclosure manufacturing method includes the following steps.

Sill. Process a metal base material into a housing of a preset structure by using a preset formation technology.

Optionally, for step Sill, reference may be specifically made to the foregoing step S31, and a first metal base material is processed into the housing of the preset structure by using a first formation technology. Alternatively, for step S111, reference may be specifically made to the foregoing step S71, and a second metal base material is processed into the housing of the preset structure by using a die casting technology and a numerical control machining technology. For a specific implementation, reference may be made to the foregoing corresponding embodiments, and details are not described herein.

S112. Dispose a protective film on a surface of the housing according to the metal base material.

S113. Perform film rupture processing on a to-be-processed region that is on the housing and on which an electrical connection contact needs to be disposed, to remove an anodized film in the to-be-processed region.

With reference to the foregoing embodiment, when the metal base material used for the housing is the first metal base material, an anodized film is disposed on the surface of the housing; and when the metal base material used for the housing is the second metal base material, a chemical conversion film is disposed on the surface of the housing. Accordingly, the anodized film or the chemical conversion film in the to-be-processed region is specifically removed by using a laser engraving or CNC machining technology in step S113. For a specific implementation, reference may also be made to the foregoing corresponding embodiments, and details are not described herein.

S1141. Deposit a nickel layer in the to-be-processed region.

S1142. Deposit a gold layer on the nickel layer.

Optionally, in this embodiment of the present invention, specifically, the nickel layer and the gold layer are successively deposited in an electroplating manner in step S1141 and step S1142. A thickness of the nickel layer at a lower layer is controlled between 10 µm and 500 µm, and a thickness of the gold layer at an upper layer is controlled to be a value greater than 200 nm at a nanometer level.

In the embodiment shown in FIG. 11, a double-layer structure is used for a thin metal layer in an electrical connection contact region, and an upper layer is a gold layer, so as to ensure that the electrical connection contact region on the housing has excellent conductivity and corrosion resistance; and a nickel layer is used at a lower layer, so as to ensure that the electrical connection contact region on the housing has fine abrasion resistance.

Based on the foregoing embodiments and corresponding test results and performance analysis, a material of the thin metal layer may be selected according to a requirement on corrosion resistance and conductivity of the electrical connection contact in an actual application scenario.

An embodiment of the present invention further provides a metal enclosure, the metal enclosure includes a housing, and the housing is formed by processing a metal base material by using a preset formation technology. A thin metal layer is deposited in an electrical connection contact region on the housing, and abrasion resistance and corrosion resistance of the thin metal layer are better than those of the metal base material.

It can be learned that for the metal enclosure in this embodiment of the present invention, a thin metal layer is deposited in an electrical connection contact region on a housing, and corrosion resistance of the thin metal layer is better than that of a metal base material used for the housing, so that in a using process, the metal base material in the electrical connection contact region is not exposed, but instead, the thin metal layer is exposed and is in contact with a metal spring plate. The thin metal layer has high abrasion resistance and high corrosion resistance, and no metal particle is generated after repeated slight rubbing between the thin metal layer and the metal spring plate. In this way, conductivity reduction of an electrical connection contact in a process of using the metal enclosure can be avoided, conduction performance between the metal enclosure and a mainboard is ensured to be always in a good state, and performance of the metal enclosure is kept fine when the metal enclosure is used as an antenna. In the prior art, a metal slice is fastened to an electrical connection contact by means of laser welding, ultrasonic welding, screwing, or the like. By contrast, in a process of manufacturing the metal enclosure in this embodiment of the present invention, deposition of the thin metal layer in the electrical connection contact region is not limited by cavity space of the housing, that is, the thin metal layer can be deposited on an electrical connection contact of any area size. Therefore, in this embodiment of the present invention, a conduction problem of an electrical connection contact on a metal enclosure can be thoroughly resolved.

Optionally, the metal enclosure in the present invention includes but is not limited to any one of the following: a middle frame, a rear cover, or a screen support board of an electronic device.

In a feasible embodiment, the housing of the foregoing metal enclosure may be a housing formed by processing a first metal base material by using a first formation technology.

The first formation technology includes but is not limited to any one of the following: stamping, forging, numerical control machining, or die casting.

The first metal base material includes but is not limited to any of the following: a 5000-series aluminum alloy, a 6000-series aluminum alloy, or a 7000-series aluminum alloy.

Based on the foregoing housing formed by processing the first metal base material, an anodized film formed by means of anodizing processing is further disposed in a non-electrical connection contact region on the housing. Specifically, the method in step S32 and step S33 in the foregoing method embodiment may be used: The anodized film is first formed on the entire housing, and then the anodized film in the electrical connection contact region is removed by using a laser engraving or CNC machining technology.

In a feasible embodiment, the housing of the foregoing metal enclosure may be a housing formed by processing a second metal base material by using a die casting technology.

The second metal base material includes but is not limited to either of the following: a die casting aluminum alloy or a die casting magnesium alloy.

Based on the foregoing housing formed by processing the second metal base material, a chemical conversion thin film formed by means of chemical conversion film processing is further disposed in a non-electrical connection contact region on the housing. Specifically, the method in step S72 and step S73 in the foregoing method embodiment may be used: The chemical conversion thin film may be first formed on the entire housing, and then the chemical conversion thin film in the electrical connection contact region is removed by using a laser engraving or CNC machining technology.

In a feasible embodiment, the thin metal layer deposited in the electrical connection contact region on the foregoing metal enclosure may be a nickel layer, and a thickness of the nickel layer is between 10 µm and 500 µm. Accordingly, for a cross-sectional structure of the metal enclosure, reference may be made to the structure corresponding to step S341 in FIG. 3, or the structure corresponding to step S741 in FIG. 7.

In the foregoing embodiment, the nickel layer is deposited in all electrical connection contact regions on the metal enclosure, so that a surface of the metal base material in the electrical connection contact region can be protected from oxidation. It can be learned from an actual test that, for the metal enclosure on which the nickel layer is deposited and that is obtained in the foregoing implementation, Z-resistance of the electrical connection contact region is less than 50 mΩ in actual measurement, and after 8-hour, 12-hour, and 24-hour neutral salt spray tests, a nickel layer of each electrical connection contact is not obviously corroded, Z-resistance is not obviously increased, and conductivity performance is kept fine. It can be learned that, in comparison with the prior art in which a metal base material of a housing is directly exposed to form an electrical connection contact, oxidation resistance and corrosion resistance of the metal enclosure manufactured in the foregoing implementation are greatly improved.

In a feasible embodiment, the thin metal layer deposited in the electrical connection contact region on the foregoing metal enclosure may be a copper layer, and a thickness of the copper layer is between 10 µm and 500 µm. Accordingly, for a cross-sectional structure of the metal enclosure, reference may be made to the structure corresponding to step S541 in FIG. 5, or the structure corresponding to step S941 in FIG. 9.

Optionally, the copper layer in this embodiment may be replaced with a copper alloy layer.

In the foregoing embodiment, the copper layer is deposited in all electrical connection contact regions on the metal enclosure, so that a surface of the metal base material in the electrical connection contact region can be protected from oxidation. It can be learned from an actual test that, for the metal enclosure on which the copper layer is deposited and that is obtained in the foregoing implementation, Z-resistance of the electrical connection contact region is less than 50 mΩ in actual measurement, and after an 8-hour neutral salt spray test, a copper layer of each electrical connection contact is not obviously corroded, Z-resistance is not obviously increased, and conductivity performance is kept fine. It can be learned that, in comparison with the prior art in which a metal base material of a housing is directly exposed to form an electrical connection contact, oxidation resistance and corrosion resistance of the metal enclosure manufactured in the foregoing implementation are greatly improved.

In a feasible embodiment, the thin metal layer deposited in the electrical connection contact region on the foregoing metal enclosure may be double thin metal layers. A specific structure of the double thin metal layers includes at least the following three cases.
(1) A lower layer is a nickel layer whose thickness is between 10 µm and 500 µm, and an upper layer is a copper layer whose thickness is between 10 µm and 500 µm. Accordingly, for a cross-sectional structure of the metal enclosure, reference may be made to the structure corresponding to step S342 in FIG. 4, or the structure corresponding to step S742 in FIG. 8.
(2) A lower layer is a copper layer whose thickness is between 10 µm and 500 µm, and an upper layer is a nickel layer whose thickness is between 10 µm and 500 µm. Accordingly, for a cross-sectional structure of the metal enclosure, reference may be made to the structure corresponding to step S542 in FIG. 6, or the structure corresponding to step S942 in FIG. 10.
(3) A lower layer is a nickel layer whose thickness is between 10 µm and 500 µm, and an upper layer is a gold layer whose thickness is greater than 200 nm. Accordingly, for a cross-sectional structure of the metal enclosure, reference may be made to the structure corresponding to step S1142 in FIG. 11.

The foregoing embodiment provides three implementations in which double thin metal layers are deposited in all electrical connection contact regions on the metal enclosure, so that the surface of the metal base material in the electrical connection contact region can be protected from oxidation. A structure in which a lower layer is a nickel layer and an upper layer is a copper layer is used as an example. It can be learned from an actual test that Z-resistance of the electrical connection contact region is less than 60 mΩ in actual measurement, and after an 8-hour neutral salt spray test, double thin metal layers of each electrical connection contact are not obviously corroded, Z-resistance is not obviously increased, and conductivity performance is kept fine.

When the gold layer is used in a double thin metal layer structure, the gold layer is disposed at an upper layer, so as to ensure that the electrical connection contact region on the housing has excellent conductivity and corrosion resistance; and the nickel layer is used as a lower layer, so as to ensure that the electrical connection contact region on the housing has fine abrasion resistance.

It can be learned that, in comparison with the prior art in which a metal base material of a housing is directly exposed to form an electrical connection contact, oxidation resistance and corrosion resistance of the metal enclosure that has the thin metal layer and that is manufactured in the foregoing implementation are greatly improved.

It may be clearly understood by persons skilled in the art that, cross reference may be made between descriptions of all the embodiments provided in the present invention. For example, for the purpose of a convenient and brief description, for functions and execution steps of each apparatus and device provided in the embodiments of the present invention, reference may be made to a corresponding description in the method embodiment of the present invention.

## Claims

1. A metal enclosure manufacturing method, comprising:
processing (S1) a metal base material into a housing of a preset structure; and
depositing (S2) a thin metal layer on a surface of the metal base material in a to-be-processed region on the housing, wherein
the to-be-processed region is a region that is on the housing and that is used as an electrical connection contact, and both abrasion resistance and corrosion resistance of the thin metal layer are better than those of the metal base material,
**characterized in that** before the depositing (S2) a thin metal layer on a surface of the metal base material in a to-be-processed region on the housing, the method further comprises:
forming an anodized or chemical conversion film on a surface of the housing by means of anodizing processing or by means of chemical conversion film processing; and
removing the anodized or chemical conversion film in the to-be-processed region by using a laser engraving technology or a numerical control machining technology, to expose the metal base material in the to-be-processed region.

2. The method according to claim 1, wherein the depositing (S2) a thin metal layer on a surface of the metal base material in a to-be-processed region on the housing comprises:
depositing the thin metal layer on the surface of the metal base material in the to-be-processed region in a preset deposition manner, wherein
the preset deposition manner comprises but is not limited to any one of the following: cold metal spraying, hot metal spraying, electroplating, or physical vapor deposition, PVD.

3. The method according to claim 1 or 2, wherein the depositing (S2) a thin metal layer on a surface of the metal base material in a to-be-processed region on the housing comprises:
depositing a nickel layer on the surface of the metal base material in the to-be-processed region; or
depositing a copper layer on the surface of the metal base material in the to-be-processed region; or
successively depositing a nickel layer and a copper layer on the surface of the metal base material in the to-be-processed region; or
successively depositing a copper layer and a nickel layer on the surface of the metal base material in the to-be-processed region; or
successively depositing a nickel layer and a gold layer on the surface of the metal base material in the to-be-processed region.

4. The method according to claim 3, wherein both a thickness of the nickel layer and a thickness of the copper layer are between 10 µm and 500 µm, and a thickness of the gold layer is greater than 200 nm.

5. The method according to claim 1, wherein the processing (S1) a metal base material into a housing of a preset structure comprises:
processing a first metal base material into the housing of the preset structure by using a first formation technology, wherein
the first formation technology comprises to any one of the following: stamping, forging, numerical control machining, or die casting; and
the first metal base material comprises any of the following: a 5000-series aluminum alloy, a 6000-series aluminum alloy, or a 7000-series aluminum alloy.

6. The method according to claim 1, wherein the processing (S1) a metal base material into a housing of a preset structure comprises:
processing a second metal base material into the housing of the preset structure by using a die casting technology and a numerical control machining technology, wherein
the second metal base material either of the following: a die casting aluminum alloy or a die casting magnesium alloy.

7. A metal enclosure, comprising a housing, wherein
a thin metal layer is deposited (S2) on a surface of a metal base material in an electrical connection contact region on the housing, and abrasion resistance and corrosion resistance of the thin metal layer are better than those of the metal base material, **characterized in that** an anodized film or a chemical conversion thin film is disposed in a non-electrical connection contact region on the housing.

8. The metal enclosure according to claim 7, wherein the thin metal layer comprises:
a nickel layer deposited on the surface of the metal base material in the electrical connection contact region; or
a copper layer deposited on the surface of the metal base material in the electrical connection contact region; or
a nickel layer and a copper layer that are successively deposited on the surface of the metal base material in the electrical connection contact region; or
a copper layer and a nickel layer that are successively deposited on the surface of the metal base material in the electrical connection contact region; or
a nickel layer and a gold layer that are successively deposited on the surface of the metal base material in the electrical connection contact region.

9. The metal enclosure according to claim 8, wherein both a thickness of the nickel layer and a thickness of the copper layer are between 10 µm and 500 µm, and a thickness of the gold layer is greater than 200 nm.

10. The metal enclosure according to claim 7, wherein the housing is a housing obtained by processing (S1) a first metal base material by using a first formation technology;
the first formation technology comprises but is not limited to any one of the following: stamping, forging, numerical control machining, or die casting; and the first metal base material comprises but is not limited to any of the following:
a 5000-series aluminum alloy, a 6000-series aluminum alloy, or a 7000-series aluminum alloy.

11. The metal enclosure according to claim 7, wherein the housing is a housing obtained by processing a second metal base material by using a die casting technology; and
the second metal base material comprises but is not limited to either of the following: a die casting aluminum alloy or a die casting magnesium alloy.

12. The metal enclosure according to claim 7, wherein the metal enclosure comprises but is not limited to any one of the following: a middle frame, a rear cover, or a screen support board of an electronic device.

## Patentansprüche

1. Herstellungsverfahren für eine Metalleinhausung, umfassend:
Verarbeiten (S1) eines Metallbasismaterials zu einem Gehäuse mit einer vorgegebenen Struktur; und
Abscheiden (S2) einer dünnen Metallschicht auf einer Oberfläche des Metallbasismaterials in einer zu verarbeitenden Region auf dem Gehäuse, wobei die zu verarbeitende Region eine Region ist, die sich auf dem Gehäuse befindet und
die als ein elektrischer Verbindungskontakt verwendet wird, und wobei sowohl Abrasionsbeständigkeit als auch Korrosionsbeständigkeit der dünnen Metallschicht besser als jene des Metallbasismaterials sind,
**dadurch gekennzeichnet, dass** das Verfahren vor dem Abscheiden (S2) einer dünnen Metallschicht auf einer Oberfläche des Metallbasismaterials in der zu verarbeitenden Region auf dem Gehäuse des Weiteren umfasst:
Bilden eines anodisierten oder chemischen Umwandlungsfilms auf einer Oberfläche des Gehäuses mittels Anodisierungsverarbeitung oder mittels chemischer Umwandlungsfilmverarbeitung; und
Entfernen des anodisierten oder chemischen Umwandlungsfilms in der zu verarbeitenden Region unter Verwendung einer Lasergraviertechnologie oder einer maschinellen Bearbeitungstechnologie mit numerischer Steuerung, um das Metallbasismaterial in der zu verarbeitenden Region zu exponieren.

2. Verfahren nach Anspruch 1, wobei das Abscheiden (S2) einer dünnen Metallschicht auf einer Oberfläche des Metallbasismaterials in einer zu verarbeitenden Region auf dem Gehäuse umfasst:
Abscheiden der dünnen Metallschicht auf der Oberfläche des Metallbasismaterials in der zu verarbeitenden Region in einer vorgegebenen Abscheideweise, wobei die vorgegebene Abscheideweise eine der folgenden umfasst, ohne jedoch darauf begrenzt zu sein: Kaltmetallspritzen, Heißmetallspritzen, Galvanisieren oder physikalische Gasphasenabscheidung, PVD.

3. Verfahren nach Anspruch 1 oder 2, wobei das Abscheiden (S2) einer dünnen Metallschicht auf einer Oberfläche des Metallbasismaterials in einer zu verarbeitenden Region auf dem Gehäuse umfasst:
Abscheiden einer Nickelschicht auf der Oberfläche des Metallbasismaterials in der zu verarbeitenden Region; oder
Abscheiden einer Kupferschicht auf der Oberfläche des Metallbasismaterials in der zu verarbeitenden Region; oder
nacheinander Abscheiden einer Nickelschicht und einer Kupferschicht auf der Oberfläche des Metallbasismaterials in der zu verarbeitenden Region; oder
nacheinander Abscheiden einer Kupferschicht und einer Nickelschicht auf der Oberfläche des Metallbasismaterials in der zu verarbeitenden Region; oder
nacheinander Abscheiden einer Nickelschicht und einer Goldschicht auf der Oberfläche des Metallbasismaterials in der zu verarbeitenden Region.

4. Verfahren nach Anspruch 3, wobei sowohl eine Dicke der Nickelschicht als auch eine Dicke der Kupferschicht zwischen 10 µm und 500 µm liegen, und eine Dicke der Goldschicht größer als 200 nm ist.

5. Verfahren nach Anspruch 1, wobei die Verarbeitung (S1) eines Metallbasismaterials zu einem Gehäuse einer vorgegebenen Struktur umfasst:
Verarbeiten eines ersten Metallbasismaterials zu dem Gehäuse der vorgegebenen Struktur unter Verwendung einer ersten Formungstechnologie, wobei die erste Formungstechnologie jedwede der Folgenden umfasst: Stanzen, Schmieden,
maschinelle Bearbeitung mit numerischer Steuerung oder Druckguss; und
das erste Metallbasismaterial jedwede der Folgenden umfasst: eine Aluminiumlegierung der 5000-Serie, eine Aluminiumlegierung der 6000-Serie oder eine Aluminiumlegierung der 7000-Serie.

6. Verfahren nach Anspruch 1, wobei die Verarbeitung (S1) eines Metallbasismaterials zu einem Gehäuse einer vorgegebenen Struktur umfasst:
Verarbeiten eines zweiten Metallbasismaterials zu dem Gehäuse der vorgegebenen Struktur unter Verwendung einer Druckgusstechnologie und einer maschinellen Bearbeitungstechnologie mit numerischer Steuerung, wobei
das zweite Metallbasismaterial eines der Folgenden: eine Druckgussaluminiumlegierung oder eine Druckgussmagnesiumlegierung.

7. Metalleinhausung, die ein Gehäuse umfasst, wobei
eine dünne Metallschicht auf einer Oberfläche eines Metallbasismaterials in einer elektrischen Verbindungskontaktregion auf dem Gehäuse abgeschieden (S2) worden ist, und wobei Abrasionsbeständigkeit und Korrosionsbeständigkeit der dünnen Metallschicht besser als jene des Metallbasismaterials sind, **dadurch gekennzeichnet, dass** ein anodisierter Film oder ein chemischer Umwandlungsdünnfilm in einer Region des Gehäuses ohne elektrischen Verbindungskontakt angeordnet ist.

8. Metalleinhausung nach Anspruch 7, wobei die dünne Metallschicht umfasst:
eine Nickelschicht, die auf der Oberfläche des Metallbasismaterials in der elektrischen Verbindungskontaktregion abgeschieden worden ist; oder
eine Kupferschicht, die auf der Oberfläche des Metallbasismaterials in der elektrischen Verbindungskontaktregion abgeschieden worden ist; oder
eine Nickelschicht und eine Kupferschicht, die nacheinander auf der Oberfläche des Metallbasismaterials in der elektrischen Verbindungskontaktregion abgeschieden worden sind; oder
eine Kupferschicht und eine Nickelschicht, die nacheinander auf der Oberfläche des Metallbasismaterials in der elektrischen Verbindungskontaktregion abgeschieden worden sind; oder
eine Nickelschicht und eine Goldschicht, die nacheinander auf der Oberfläche des Metallbasismaterials in der elektrischen Verbindungskontaktregion abgeschieden worden sind.

9. Metalleinhausung nach Anspruch 8, wobei sowohl eine Dicke der Nickelschicht als auch eine Dicke der Kupferschicht zwischen 10 µm und 500 µm liegen, und eine Dicke der Goldschicht größer als 200 nm ist.

10. Metalleinhausung nach Anspruch 7, wobei das Gehäuse ein Gehäuse ist, das durch Verarbeitung (S1) eines ersten Metallbasismaterials unter Verwendung einer ersten Formungstechnologie erhalten wurde;
wobei die erste Formungstechnologie jedwede der Folgenden umfasst, ohne jedoch darauf begrenzt zu sein: Stanzen, Schmieden, maschinelle Bearbeitung mit numerischer Steuerung oder Druckguss; und
das erste Metallbasismaterial jedwede der Folgenden umfasst, ohne jedoch darauf begrenzt zu sein: eine Aluminiumlegierung der 5000-Serie, eine Aluminiumlegierung der 6000-Serie oder eine Aluminiumlegierung der 7000-Serie.

11. Metalleinhausung nach Anspruch 7, wobei das Gehäuse ein Gehäuse ist, das durch Verarbeitung eines zweiten Metallbasismaterials unter Verwendung einer Druckgusstechnologie erhalten worden ist; und
das zweite Metallbasismaterial eines der Folgenden umfasst, jedoch nicht darauf begrenzt ist: eine Druckgussaluminiumlegierung oder eine Druckgussmagnesiumlegierung.

12. Metalleinhausung nach Anspruch 7, wobei die Metalleinhausung jedwede der Folgenden umfasst, ohne jedoch darauf begrenzt zu sein: einen Mittelrahmen, eine Rückseitenabdeckung oder eine Bildschirmhalteplatte einer elektronischen Vorrichtung.

## Revendications

1. Procédé de fabrication d'une enveloppe métallique, comprenant :
la transformation (S1) d'un matériau métallique de base en un boîtier d'une structure prédéfinie ; et
le dépôt (S2) d'une couche mince métallique sur une surface du matériau métallique de base dans une région à traiter sur le boîtier, dans lequel
la région à traiter est une région qui est sur le boîtier et qui est utilisée comme un contact de connexion électrique, et la résistance à l'abrasion et la résistance à la corrosion de la couche mince métallique sont toutes deux meilleures que celles du matériau métallique de base,
**caractérisé en ce que**, avant le dépôt (S2) d'une couche mince métallique sur une surface du matériau métallique de base dans une région à traiter sur le boîtier, le procédé comprend en outre :
la formation d'un film anodisé ou de conversion chimique sur une surface du boîtier au moyen d'un traitement d'anodisation ou au moyen d'un traitement de film de conversion chimique ; et
le retrait du film anodisé ou de conversion chimique dans la région à traiter au moyen d'une technologie de gravure au laser ou d'une technologie d'usinage à commande numérique, pour exposer le matériau métallique de base dans la région à traiter.

2. Procédé selon la revendication 1, dans lequel le dépôt (S2) d'une couche mince métallique sur une surface du matériau métallique de base dans une région à traiter sur le boîtier comprend :
le dépôt de la couche mince métallique sur la surface du matériau métallique de base dans la région à traiter par une méthode de dépôt prédéfinie, dans lequel
la méthode de dépôt prédéfinie comprend, mais sans s'y limiter, l'une quelconque des méthodes suivantes : projection de métal à froid, projection de métal à chaud, dépôt électrolytique, ou dépôt physique en phase vapeur, PVD

3. Procédé selon la revendication 1 ou 2, dans lequel le dépôt (S2) d'une couche mince métallique sur une surface du matériau métallique de base dans une région à traiter sur le boîtier comprend :
le dépôt d'une couche de nickel sur la surface du matériau métallique de base dans la région à traiter ; ou
le dépôt d'une couche de cuivre sur la surface du matériau métallique de base dans la région à traiter ; ou
le dépôt successif d'une couche de nickel et d'une couche de cuivre sur la surface du matériau métallique de base dans la région à traiter ; ou
le dépôt successif d'une couche de cuivre et d'une couche de nickel sur la surface du matériau métallique de base dans la région à traiter ; ou
le dépôt successif d'une couche de nickel et d'une couche d'or sur la surface du matériau métallique de base dans la région à traiter.

4. Procédé selon la revendication 3, dans lequel une épaisseur de la couche de nickel et une épaisseur de la couche de cuivre se situent toutes deux entre 10 µm et 500 µm, et une épaisseur de la couche d'or est supérieure à 200 nm.

5. Procédé selon la revendication 1, dans lequel la transformation (S1) d'un matériau métallique de base en un boîtier d'une structure prédéfinie comprend :
la transformation d'un premier matériau métallique de base en le boîtier de la structure prédéfinie au moyen d'une première technologie de formation, dans lequel la première technologie de formation comprend l'une quelconque des technologies suivantes : estampage, forgeage, usinage à commande numérique, ou moulage sous pression ; et
le premier matériau métallique de base comprend l'un quelconque des matériaux suivants : un alliage d'aluminium de la série 5000, un alliage d'aluminium de la série 6000, ou un alliage d'aluminium de la série 7000.

6. Procédé selon la revendication 1, dans lequel la transformation (S1) d'un matériau métallique de base en un boîtier d'une structure prédéfinie comprend :
la transformation d'un deuxième matériau métallique de base en le boîtier de la structure prédéfinie au moyen d'une technologie de moulage sous pression et d'une technologie d'usinage à commande numérique, dans lequel
le deuxième matériau métallique de base l'un des matériaux suivants : un alliage d'aluminium pour moulage sous pression ou un alliage de magnésium pour moulage sous pression.

7. Enveloppe métallique, comprenant un boîtier, dans laquelle
une couche mince métallique est déposée (S2) sur une surface d'un matériau métallique de base dans une région de contact de connexion électrique sur le boîtier, et la résistance à l'abrasion et la résistance à la corrosion de la couche mince métallique sont meilleures que celles du matériau métallique de base, **caractérisée en ce qu'**un film anodisé ou un film mince de conversion chimique est disposé dans une région qui n'est pas une région de contact de connexion électrique sur le boîtier.

8. Enveloppe métallique selon la revendication 7, dans laquelle la couche mince métallique comprend :
une couche de nickel déposée sur la surface du matériau métallique de base dans la région de contact de connexion électrique ; ou
une couche de cuivre déposée sur la surface du matériau métallique de base dans la région de contact de connexion électrique ; ou
une couche de nickel et une couche de cuivre qui sont successivement déposées sur la surface du matériau métallique de base dans la région de contact de connexion électrique ; ou
une couche de cuivre et une couche de nickel qui sont successivement déposées sur la surface du matériau métallique de base dans la région de contact de connexion électrique ; ou
une couche de nickel et une couche d'or qui sont successivement déposées sur la surface du matériau métallique de base dans la région de contact de connexion électrique.

9. Enveloppe métallique selon la revendication 8, dans laquelle une épaisseur de la couche de nickel et une épaisseur de la couche de cuivre se situent toutes deux entre 10 µm et 500 µm, et une épaisseur de la couche d'or est supérieure à 200 nm.

10. Enveloppe métallique selon la revendication 7, dans laquelle le boîtier est un boîtier obtenu par transformation (S1) d'un premier matériau métallique de base au moyen d'une première technologie de formation ;
la première technologie de formation comprend, mais sans s'y limiter, l'une quelconque des technologies suivantes : estampage, forgeage, usinage à commande numérique, ou moulage sous pression ; et
le premier matériau métallique de base comprend, mais sans s'y limiter, l'un quelconque des matériaux suivants : un alliage d'aluminium de la série 5000, un alliage d'aluminium de la série 6000, ou un alliage d'aluminium de la série 7000.

11. Enveloppe métallique selon la revendication 7, dans laquelle le boîtier est un boîtier obtenu par transformation d'un deuxième matériau métallique de base au moyen d'une technologie de moulage sous pression ; et
le deuxième matériau métallique de base comprend, mais sans s'y limiter, l'un des matériaux suivants : un alliage d'aluminium pour moulage sous pression ou un alliage de magnésium pour moulage sous pression.

12. Enveloppe métallique selon la revendication 7, l'enveloppe métallique comprenant, mais sans s'y limiter, l'un quelconque des composants suivants : un châssis central, un capot arrière, ou une plaque de support d'écran d'un dispositif électronique.
